# EUROPEAN PATENT SPECIFICATION

(11) **EP 4 548 435 B1**
(45) Date of publication and mention of the grant of the patent: **25.03.2026**
(21) Application number: 23737977.1
(22) Date of filing: 30.06.2023
(51) Int. Cl.: H01R 13/641, H01R 13/66, H05K 1/11, B60R 16/02, H01R 12/72, B60Q 1/00, H05K 1/02, H05K 1/14, H01R 107/00

(54) **AUTOMOTIVE LUMINOUS DEVICE**
ELEKTRONISCHE VORRICHTUNG FÜR EIN KRAFTFAHRZEUG
DISPOSITIF ÉLECTRONIQUE POUR VÉHICULE AUTOMOBILE

(30) Priority: 30.06.2022 FR 2206702
(43) Date of publication of application: 07.05.2025
(73) Proprietor: VALEO VISION, 93012 Bobigny Cedex (FR)
(72) Inventor: CANTUDO, Miguel-Angel, 23600 MARTOS (ES)
(74) Representative: Valeo Visibility
(86) International application number: PCT/EP2023/068095
(87) International publication number: WO 2024/003384

(56) References cited:
- EP-A1- 3 756 948
- CN-U- 216 556 930
- FR-A1- 3 056 702
- FR-A1- 3 116 887
- JP-A- 2013 100 056

## Description

This invention is related to the field of automotive lighting devices, and more particularly, to systems and devices which transmit electric signals between the different parts.

### State of the art

A light module for a motor vehicle is a complex device involving a plurality of technologies in a very small space. It includes optical components, light components such as light emitting diodes, LEDs, electronic circuits for driving light sources, mechanical supports, and elements for dissipating humidity and heat. The assembly of such a module is a complex task that requires a high degree of attention and precision. This is particularly the case for the electrical interconnection of the various electrical components and/or printed circuits involved in such a light module. For example, a control circuit for the power supply of light sources must be connected via a connector to a printed circuit board that includes the light sources to be supplied with electricity. An operator usually performs these connections without having direct visual contact of the connector and the corresponding socket - the operation has to be done blindly due to the fact that other components are already assembled in the limited space available in the module.

There are different ways to reduce the amount of wire harnesses which are present in these devices. Such a solution is proposed in CN 216 556 930 U. However, it is not easy to provide the same number of functionalities with a lower quantity of cables, since they are used both to provide power supply and control signals.

A particular example is the case where a printed circuit board comprises the main driver and different printed circuit boards comprises light sources which are intended to be controlled by said driver. In this case, the printed circuit board of the driver must be connected with each one of the printed circuit boards comprising one of the light sources. Therefore, the number of pins needs to be multiplied or create splices in the harnesses.

An alternative solution for this problem is therefore sought.

### Object of the invention

The invention provides a solution for this problem by an automotive lighting device. This automotive luminous device comprises:
- a main substrate, the main substrate comprising a driver and electric tracks which start in an edge portion of the main substrate and communicate the edge portion with the driver;
- a main connector coupled to the edge portion of the main substrate, the main connector comprising at least four electrical inputs and four electrical outputs, each electrical input being configured to receive power supply and control signals and being electrically coupled to an electric track of the main substrate and each electrical output being electrically coupled to an electric track of the main substrate;
- a first secondary substrate, the first secondary substrate comprising at least one light source intended to be commanded by the driver of the main substrate, and electric tracks which start in an edge portion of the first secondary substrate and communicate the edge portion with the light source;
- a first secondary connector coupled to the edge portion of the first secondary substrate, the first secondary connector comprising at least four inputs, each input being connected by wire with one output of the main connector, and four outputs;
- a second secondary substrate, the second secondary substrate comprising at least one light source intended to be commanded by the driver of the main substrate, and electric tracks which start in an edge portion of the second secondary substrate and communicate the edge portion with the light source;
- a second secondary connector coupled to the edge portion of the second secondary substrate, the second secondary connector comprising at least four inputs, each input being connected by wire with one output of the first secondary connector.

In such an automotive luminous device, more than one substrate is used with light sources, and all the light sources are connected to the driver, by means of a daisy-chain assembly. The connection between the driver and each light source is carried out by the interposition of other substrates.

A substrate is an element which serves as a support for a circuit. A typical example of substrate is a printed circuit board.

In some particular embodiments,
- the second secondary connector further comprises at least four outputs;
- the lighting device further comprises a third secondary substrate and a third secondary connector;
- the third secondary substrate comprises at least one light source intended to be commanded by the driver of the main substrate, and electric tracks which start in an edge portion of the third secondary substrate and communicate the edge portion with the light source; and
- the third secondary connector is coupled to the edge portion of the third secondary substrate, the third secondary connector comprising at least four inputs, each input being connected by wire with one output of the second secondary connector.

This structure may be repeated several times, since the invention supports the connection of successive substrates with connectors having inputs and outputs, wherein the inputs come from the outputs of the preceding connector and the outputs (except for the last connector, which does not have any output) are connected to the inputs of the subsequent connector.

In some particular embodiments, one of the electric tracks is configured to provide information about the electric connection between the corresponding connector and the corresponding edge portion.

This track is a connection position assurance track, which informs about the electric connection between the connector and the edge portion. There are multiple ways of performing this action. Such connectors typically have a plurality of contacts having a first length and a shorter verification contact, which only reliably makes electrical contact with a corresponding terminal of a receptacle if a certain depth of depression of the plug into the receptacle is achieved.

In some particular embodiments, the electric track configured to provide information about the electric connection between the corresponding connector and the corresponding edge portion is arranged in an independent electric circuit which is separate from the light source.

As a consequence, the connection position assurance issue and the luminous function issue are decoupled.

In some particular embodiments, the independent electric circuit comprises a first branch which connects the electric track configured to provide information about the electric connection with the driver and a second branch with a resistor, which connects a node of the first branch with ground.

This is a very interesting question, since the driver receives the information about the connection position assurance. Each driver may manage this information in their own suitable way.

In some particular embodiments, the automotive luminous device further comprises a heatsink, and the independent electric circuit comprises a first branch which connects the electric track configured to provide information about the electric connection with the heatsink and a second branch with a resistor, which connects a node of the first branch with ground.

In this embodiment, the heatsink, which is a conductive part, has the information about connection position assurance in its metallic body. A measurement of the impedance between this body and the ground is enough to check if the connectors are properly connected or not.

In some particular embodiments, one of the electric tracks is configured to provide information about diagnosis concerning the state of the light source of the corresponding substrate.

The driver may use the information about diagnosis in its own suitable way.

In some particular embodiments, the inputs and the outputs of at least one of the connectors are located in opposite faces of the corresponding connector.

A connector has a shape similar to a parallelepiped. It has six faces which are opposite two by two. One first face is used to receive the insertion of the edge of the substrate. There are, therefore, four faces which are substantially perpendicular to this first face. Because of the natural shape, two of these faces are larger than the other two. In these larger faces, the inputs and the outputs are arranged.

In some particular embodiments, at least one of the connectors comprises first mechanical retaining means and the corresponding substrate comprises mechanical second mechanical retaining means configured to cooperate with the first mechanical retaining means to retain the connector

In particular embodiments, these mechanical retaining means are located in the smaller faces which are perpendicular to the first face, receiving the connection from the edge of the substrate. These are the lateral faces, which usually embrace the connection and has the mechanical retention means to avoid the disconnection between the connection and the edge portion of the substrate.

In some particular embodiments, the first mechanical retaining means and the second mechanical retaining means comprises an arm-protrusion pair, or a hook-latch pair or a snap-fit connection.

In some particular embodiments, the light sources of the secondary substrates are configured to cooperate in the provision of different lighting or signalling functions.

This means that there are different lighting or signalling functions, and that the light sources of the substrates cooperate in the provision of these lighting or signalling functions. This may be because each substrate is dedicated to one of the lighting or signalling functions or because there are several substrates dedicated to one function and other or others substrates dedicated to one or more functions.

In some particular embodiments, the light sources of at least two secondary substrates are configured to cooperate in the provision of the same lighting or signalling function.

In some particular embodiments, the connectors are card edge connectors and the light sources are solid-state light sources, such as light emitting diodes.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the lifespan of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas.

In some particular embodiments, the automotive luminous device further comprises at least one optical element configured to receive the light emitted by the light sources and project it outside the luminous device.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements which are useful for transforming the light beams emitted by the light source into an acceptable light pattern for the functionality chosen for the lighting device. All of these optical elements define a focus, which is the point where the light emitted by the light source is most effectively transmitted by the optical element.

In some particular embodiments, the main connector is fed at a voltage value of 5 V or 12V.

These are typical values for automotive luminous devices.

In some particular embodiments, the wires comprise harness protection elements.

In some particular embodiments, the light sources are light emitting diodes and the first substrate is configured to provide a matrix beam functionality.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

### List of figures

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:

In these figures, the following reference numbers have been used:
1 Main PCB
2 Driver
3 Main connector
4 First secondary PCB
5 First secondary connector
6 Second secondary PCB
7 Second secondary connector
8 Heatsink
9 LED
10 Headlamp
11 Edge portion of the main PCB
12 Third secondary PCB
13 Third secondary connector
14 Edge portion of the third secondary PCB
15 Inputs of the third secondary connector
16 First retaining means
17 Electric tracks
18 Second retaining means
20 CPA track
21 First branch
22 Second branch
23 Resistor
27 Projection of electric contact against the PCB
100 Automotive vehicle

### Description of figures

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications and alternatives falling within the scope of the appended claims should be included. Elements of the example embodiments are consistently denoted by the same reference numerals throughout the drawings and detailed description where appropriate.

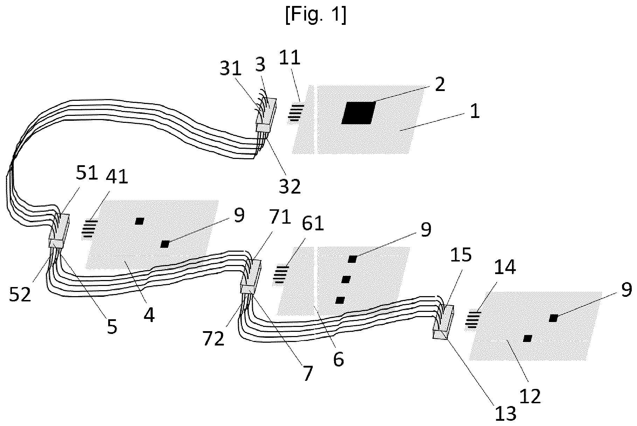

[Fig. 1] shows a scheme of the connection assembly of an automotive luminous device according to the invention.

A main printed circuit board 1 comprises an electronic circuit. This electronic circuit starts in an edge portion 11 of the main printed circuit board 1 and communicate this edge portion 11 with a driver 2, which is intended to manage the lighting and signalling functions of the light sources located in the luminous device.

A main connector 3 is coupled to the edge portion 11 of the main substrate 1. This main connector 3 provides the main printed circuit board 1 with power supply and control signals coming from the body control module of the vehicle.

The main connector 3 comprises five electrical inputs 31 and five electrical outputs 32. The electrical inputs 31 are configured to transmit the power supply and the control signals to the main printed circuit board 1. To achieve this aim, they couple electrically to the electric tracks of the main substrate 1 when the main connector 3 is plugged into the edge portion 11 of the main printed circuit board 1.

The electrical outputs 32 are also coupled to the electrical tracks of the opposite side of the main printed circuit board 1.

There are also three secondary printed circuit boards 4, 6, 12. In different embodiments, there may be more secondary printed circuit boards, since the invention is not limited to a specific number of them.

Each secondary printed circuit boards 4, 6, 12 comprises a LED 9 and electric tracks which communicate the edge portions 41, 61, 14 of the corresponding secondary printed circuit board with the corresponding LED 9.

The LEDs 9 of each secondary printed circuit board 4, 6, 12 are intended to be controlled by the driver 2 of the main printed circuit board 1.

This control is achieved by means of a daisy-chain connection, as shown in [Fig. 1].

The main connector 3 is coupled to the edge portion 11 of the main printed circuit board 1. Each electrical input 31 is configured to receive power supply and control signals from the body control module and is electrically coupled to an electric track of the main printed circuit board 1. After feeding the circuit of the main printed circuit board 1, the electric tracks of the opposite side are coupled to the electrical outputs 32 of the main connector 3.

The first secondary connector 5 is coupled to the edge portion of the first secondary printed circuit board 4. The first secondary connector comprises five inputs 51, each input 51 being connected by wire with one output 32 of the main connector 3. After feeding the circuit of the first secondary printed circuit board 4, the electric tracks of the opposite side are coupled to the electrical outputs 52 of the first secondary connector 5.

The second secondary connector 7 is coupled to the edge portion of the second secondary printed circuit board 6. The second secondary connector 7 comprises five inputs 71, each input 71 being connected by wire with one output 52 of the first secondary connector 5. After feeding the circuit of the second secondary printed circuit board 6, the electric tracks of the opposite side are coupled to the electrical outputs 72 of the second secondary connector 7.

The third secondary connector 13 is coupled to the edge portion of the third secondary printed circuit board 12. The third secondary connector 13 comprises five inputs 15, each input 15 being connected by wire with one output 72 of the second secondary connector 7.

Hence, control and power passes through all the printed circuit boards in a daisy-chain connection, instead of being delivered from the main printed circuit board in separate harnesses. This type of connection renders the use of big connectors unnecessary, since the whole control of three different printed circuit boards is done with five inputs and five outputs.

In some cases, where the distance between the different printed circuit boards is long enough, the wires for the communication bus (for instance CAN) would be twisted between themselves while the rest of wires remain straight.

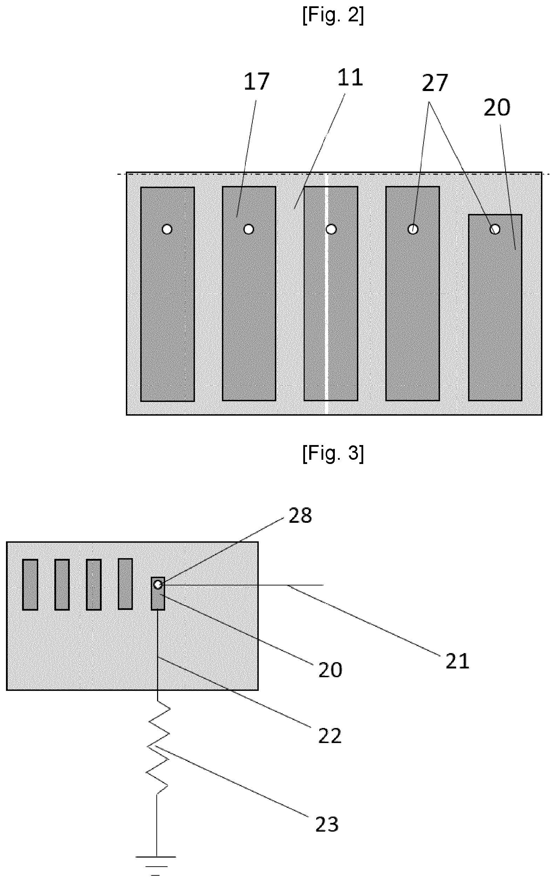

[Fig. 2] shows a particular feature of this connection: one of the lines is dedicated to connector position assurance. This figure shows the electric tracks 17 of an edge portion 11 of one of the printed circuit boards. As may be seen in this figure, each edge portion of the printed circuit boards comprises a connector position assurance track 20. In this figure, the projections 27 of the electric contacts of the connector are also shown. The connector position assurance track 20 is shorter than the rest of the tracks 17, so that it only makes electric contact with the corresponding electric contact of the respective connector when the rest of the electric tracks have achieved this electric contact with their electric contact.

This connection between the connector position assurance track 20 and its corresponding electric contact feeds one sub-circuit which is independent from the one of the light source.

[Fig. 3] shows a first example of this sub-circuit. The components of this sub-circuit do not actively participate in the lighting function performed by the LEDs. The main function of this sub-circuit is to cooperate electrically with the contact between the connector position assurance track 20 and its electric contact 28. The presence of current in this line of the circuit indicates that the connection is successfully achieved so all of the electric tracks are successfully coupled with the corresponding connections of the connector.

This sub-circuit has a first branch 21, which contains the electric contact 28, and a second branch 22, which comprises a resistor 23 which is grounded. When the circuit is closed (i.e., when the connector position assurance track is connected to the electric contact 28), the first branch sees the resistor value.

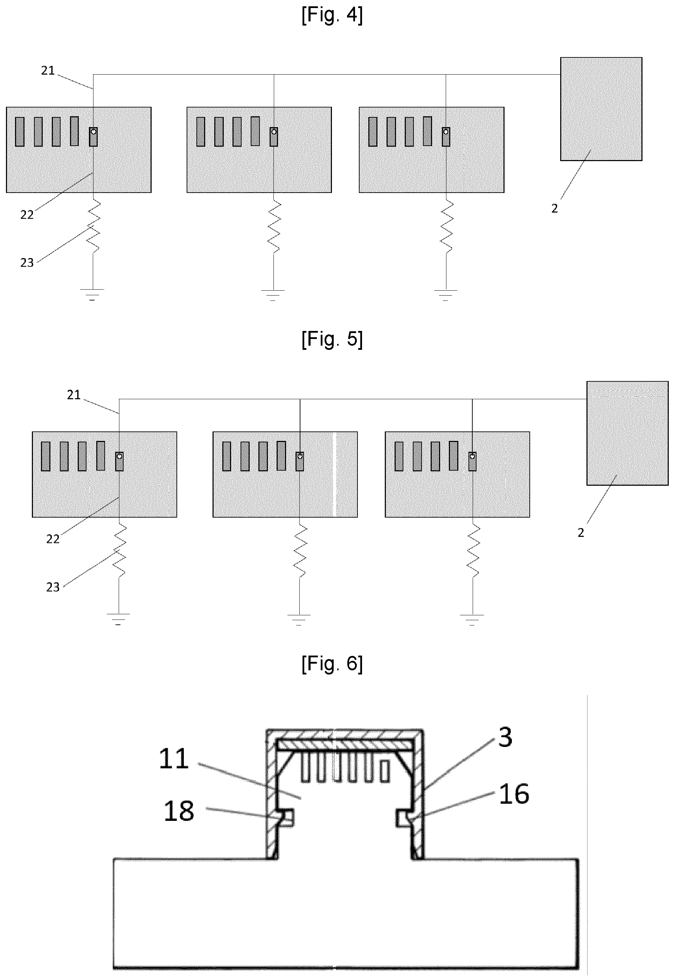

[Fig. 4] shows the connection of all the sub-circuits according to an embodiment of the invention. In this case, the connector position assurance lines are connected in parallel and the single connection is fed to a control output of the driver 2, which is capable of measuring this equivalent resistor value.

Since each sub-circuit has its own resistor value, the signal at the control output of the driver provides information about the connection state of every printed circuit board: if every connector is properly connected, the control output will see all the resistors in parallel. However, if one of them is not connected, the control output will see a different value, depending on which is the resistor that is not connected to the circuit. Thus, the control of all the printed circuit boards is performed with a single control output in the driver.

A different embodiment is shown in [Fig. 5]. In this case, the sub-circuits are the same, but instead of being connected to a control output of the driver, they are connected to the heatsink 8, which is a metallized part. The heatsink will therefore being connected to ground and provide the information about the equivalent resistor value of the connector position assurance tracks. To check if every connector is suitably connected to the corresponding printed circuit board, this equivalent impedance is measured in an easy process. The result will provide the information necessary to know if every connector is connected and, in the event any connector is failing, which is the one that fails.

[Fig. 6] shows an embodiment of the mechanical coupling between each connector 3 and the edge portion 11 of their respective printed circuit board.

A connector 3 has a shape similar to a parallelepiped. It has six faces which are opposite two by two. One first face is used to receive the insertion of the edge 11 of the printed circuit board. There are, therefore, four faces which are substantially perpendicular to this first face. In these larger faces, the inputs and the outputs are arranged.

The mechanical retaining means 16 are located in the lateral faces, which usually embrace the connection and has the mechanical retention means 16 to avoid the disconnection between the connection and the edge portion of the substrate.

In this case, the mechanical retention means are in the shape of a snap fit connection, with a groove 18 in the edge portion 11, although any other suitable way of achieving this goal is within the scope of protection of this invention..

## Claims

1. Automotive luminous device (10) comprising
- a main substrate (1), the main substrate (1) comprising a driver (2) and electric tracks which start in an edge portion (11) of the main substrate and communicate the edge portion (11) with the driver (2);
- a main connector (3) coupled to the edge portion (11) of the main substrate (1), the main connector (3) comprising at least four electrical inputs (31) and four electrical outputs (32), each electrical input (31) being configured to receive power supply and control signals and being electrically coupled to an electric track of the main substrate (1) and each electrical output (32) being electrically coupled to an electric track of the main substrate (1);
- a first secondary substrate (4), the first secondary substrate comprising at least one light source (9) intended to be commanded by the driver (2) of the main substrate (1), and electric tracks which start in an edge portion (41) of the first secondary substrate (4) and communicate the edge portion (41) with the light source (9);
- a first secondary connector (5) coupled to the edge portion of the first secondary substrate, the first secondary connector comprising at least four inputs (51), each input being connected by wire with one output (32) of the main connector (3), and four outputs (52);
- a second secondary substrate (6), the second secondary substrate comprising at least one light source (9) intended to be commanded by the driver (2) of the main substrate (1), and electric tracks which start in an edge portion (61) of the second secondary substrate (6) and communicate the edge portion (61) with the light source (9);
- a second secondary connector (7) coupled to the edge portion (61) of the second secondary substrate (6), the second secondary connector (7) comprising at least four inputs (71), each input (71) being connected by wire with one output (52) of the first secondary connector (5).

2. Automotive luminous device according to claim 1, wherein
- the second secondary connector further comprises at least four outputs (72);
- the lighting device further comprises a third secondary substrate (12) and a third secondary connector (13);
- the third secondary substrate (12) comprises at least one light source (9) intended to be commanded by the driver of the main substrate, and electric tracks which start in an edge portion (14) of the third secondary substrate (12) and communicate the edge portion (14) with the light source (9); and
- the third secondary connector (13) is coupled to the edge portion (14) of the third secondary substrate (12), the third secondary connector (13) comprising at least four inputs (15), each input being connected by wire with one output (72) of the second secondary connector.

3. Automotive luminous device according to any of the preceding claims, wherein one of the electric tracks is configured to provide information about the electric connection between the corresponding connector and the corresponding edge portion.

4. Automotive luminous device according to claim 3, wherein the electric track configured to provide information about the electric connection between the corresponding connector and the corresponding edge portion is arranged in an independent electric circuit which is separate from the light source.

5. Automotive luminous device according to claim 4, wherein the independent electric circuit comprises a first branch (21) which connects the electric track configured to provide information about the electric connection with the driver and a second branch (22) with a resistor (23), which connects a node of the first branch (21) with ground.

6. Automotive luminous device according to claim 4, further comprising a heatsink (8), and wherein the independent electric circuit comprises a first branch (21) which connects the electric track configured to provide information about the electric connection with the heatsink (8) and a second branch (22) with a resistor (23), which connects a node of the first branch with ground.

7. Automotive luminous device according to any of the preceding claims, wherein one of the electric tracks is configured to provide information about diagnosis concerning the state of the light source of the corresponding substrate.

8. Automotive luminous device according to any of the preceding claims, wherein the inputs and the outputs of at least one of the connectors are located in opposite faces of the corresponding connector.

9. Automotive luminous device according to any of the preceding claims, wherein
- at least one of the connectors comprises first mechanical retaining means (16) and the corresponding substrate comprises mechanical second mechanical retaining means (17) configured to cooperate with the first mechanical retaining means to retain the connector
- the first mechanical retaining means (16) and the second mechanical retaining means (18) comprises an arm-protrusion pair, or a hook-latch pair or a snap-fit connection.

10. Automotive luminous device according to any of the preceding claims, wherein the connectors are card edge connectors and the light sources are solid-state light sources, such as light emitting diodes.

## Patentansprüche

1. Fahrzeugleuchtenvorrichtung (10), umfassend
- ein Hauptsubstrat (1), wobei das Hauptsubstrat (1) einen Treiber (2) und elektrische Leiterbahnen umfasst, die in einem Randbereich (11) des Hauptsubstrats beginnen und den Randbereich (11) mit dem Treiber (2) verbinden;
- einen Hauptverbinder (3), der mit dem Randbereich (11) des Hauptsubstrats (1) gekoppelt ist, wobei der Hauptverbinder (3) mindestens vier elektrische Eingänge (31) und vier elektrische Ausgänge (32) umfasst, wobei jeder elektrische Eingang (31) konfiguriert ist, um Stromversorgung und Steuersignale zu empfangen und elektrisch mit einer elektrischen Leiterbahn des Hauptsubstrats (1) gekoppelt ist, und jeder elektrische Ausgang (32) elektrisch mit einer elektrischen Leiterbahn des Hauptsubstrats (1) gekoppelt ist;
- ein erstes Sekundärsubstrat (4), wobei das erste Sekundärsubstrat mindestens eine Lichtquelle (9) umfasst, die vom Treiber (2) des Hauptsubstrats (1) gesteuert werden soll, und elektrische Leiterbahnen, die in einem Randbereich (41) des ersten Sekundärsubstrats (4) beginnen und den Randbereich (41) mit der Lichtquelle (9) verbinden;
- einen ersten Sekundärverbinder (5), der mit dem Randbereich des ersten Sekundärsubstrats gekoppelt ist, wobei der erste Sekundärverbinder mindestens vier Eingänge (51) umfasst, wobei jeder Eingang durch einen Draht mit einem Ausgang (32) des Hauptverbinders (3) verbunden ist, und vier Ausgänge (52);
- ein zweites Sekundärsubstrat (6), wobei das zweite Sekundärsubstrat mindestens eine Lichtquelle (9) umfasst, die vom Treiber (2) des Hauptsubstrats (1) gesteuert werden soll, und elektrische Leiterbahnen, die in einem Randbereich (61) des zweiten Sekundärsubstrats (6) beginnen und den Randbereich (61) mit der Lichtquelle (9) verbinden;
- einen zweiten Sekundärverbinder (7), der mit dem Randbereich (61) des zweiten Sekundärsubstrats (6) gekoppelt ist, wobei der zweite Sekundärverbinder (7) mindestens vier Eingänge (71) umfasst, wobei jeder Eingang (71) durch einen Draht mit einem Ausgang (52) des ersten Sekundärverbinders (5) verbunden ist.

2. Fahrzeugleuchtenvorrichtung nach Anspruch 1, wobei
- der zweite Sekundärverbinder ferner mindestens vier Ausgänge (72) umfasst;
- die Beleuchtungsvorrichtung ferner ein drittes Sekundärsubstrat (12) und einen dritten Sekundärverbinder (13) umfasst;
- das dritte Sekundärsubstrat (12) mindestens eine Lichtquelle (9) umfasst, die vom Treiber des Hauptsubstrats gesteuert werden soll, und elektrische Leiterbahnen, die in einem Randbereich (14) des dritten Sekundärsubstrats (12) beginnen und den Randbereich (14) mit der Lichtquelle (9) verbinden; und
- der dritte Sekundärverbinder (13) mit dem Randbereich (14) des dritten Sekundärsubstrats (12) gekoppelt ist, wobei der dritte Sekundärverbinder (13) mindestens vier Eingänge (15) umfasst, wobei jeder Eingang durch einen Draht mit einem Ausgang (72) des zweiten Sekundärverbinders verbunden ist.

3. Fahrzeugleuchtenvorrichtung nach einem der vorhergehenden Ansprüche, wobei eine der elektrischen Leiterbahnen konfiguriert ist, um Informationen über die elektrische Verbindung zwischen dem entsprechenden Verbinder und dem entsprechenden Randbereich bereitzustellen.

4. Fahrzeugleuchtenvorrichtung nach Anspruch 3, wobei die elektrische Leiterbahn, die konfiguriert ist, um Informationen über die elektrische Verbindung zwischen dem entsprechenden Verbinder und dem entsprechenden Randbereich bereitzustellen, in einem unabhängigen elektrischen Schaltkreis angeordnet ist, der von der Lichtquelle getrennt ist.

5. Fahrzeugleuchtenvorrichtung nach Anspruch 4, wobei der unabhängige elektrische Schaltkreis einen ersten Zweig (21), der die elektrische Leiterbahn, die konfiguriert ist, um Informationen über die elektrische Verbindung bereitzustellen, mit dem Treiber verbindet, und einen zweiten Zweig (22) mit einem Widerstand (23) umfasst, der einen Knoten des ersten Zweigs (21) mit Masse verbindet.

6. Fahrzeugleuchtenvorrichtung nach Anspruch 4, ferner umfassend einen Kühlkörper (8), und wobei der unabhängige elektrische Schaltkreis einen ersten Zweig (21), der die elektrische Leiterbahn, die konfiguriert ist, um Informationen über die elektrische Verbindung bereitzustellen, mit dem Kühlkörper (8) verbindet, und einen zweiten Zweig (22) mit einem Widerstand (23) umfasst, der einen Knoten des ersten Zweigs mit Masse verbindet.

7. Fahrzeugleuchtenvorrichtung nach einem der vorhergehenden Ansprüche, wobei eine der elektrischen Leiterbahnen konfiguriert ist, um Diagnoseinformationen bezüglich des Zustands der Lichtquelle des entsprechenden Substrats bereitzustellen.

8. Fahrzeugleuchtenvorrichtung nach einem der vorhergehenden Ansprüche, wobei die Eingänge und die Ausgänge von mindestens einem der Verbinder in gegenüberliegenden Flächen des entsprechenden Verbinders angeordnet sind.

9. Fahrzeugleuchtenvorrichtung nach einem der vorhergehenden Ansprüche, wobei
- - mindestens einer der Verbinder erste mechanische Haltemittel (16) umfasst und das entsprechende Substrat zweite mechanische Haltemittel (17) umfasst, die konfiguriert sind, um mit den ersten mechanischen Haltemitteln zusammenzuwirken, um den Verbinder zu halten
- - die ersten mechanischen Haltemittel (16) und die zweiten mechanischen Haltemittel (18) ein Arm-Vorsprung-Paar oder ein Haken-Riegel-Paar oder eine Schnappverbindung umfassen.

10. Fahrzeugleuchtenvorrichtung nach einem der vorhergehenden Ansprüche, wobei die Verbinder Kartenkantenverbinder sind und die Lichtquellen Festkörperlichtquellen, wie Leuchtdioden, sind.

## Revendications

1. Dispositif lumineux automobile (10) comprenant
- un substrat principal (1), le substrat principal (1) comprenant un pilote (2) et des pistes électriques qui partent d'une partie de bord (11) du substrat principal et relient la partie de bord (11) au pilote (2) ;
- un connecteur principal (3) couplé à la partie de bord (11) du substrat principal (1), le connecteur principal (3) comprenant au moins quatre entrées électriques (31) et quatre sorties électriques (32), chaque entrée électrique (31) étant configurée pour recevoir l'alimentation électrique et des signaux de commande et étant électriquement couplée à une piste électrique du substrat principal (1) et chaque sortie électrique (32) étant électriquement couplée à une piste électrique du substrat principal (1) ;
- un premier substrat secondaire (4), le premier substrat secondaire comprenant au moins une source lumineuse (9) destinée à être commandée par le pilote (2) du substrat principal (1), et des pistes électriques qui partent d'une partie de bord (41) du premier substrat secondaire (4) et relient la partie de bord (41) à la source lumineuse (9) ;
- un premier connecteur secondaire (5) couplé à la partie de bord du premier substrat secondaire, le premier connecteur secondaire comprenant au moins quatre entrées (51), chaque entrée étant connectée par fil avec une sortie (32) du connecteur principal (3), et quatre sorties (52) ;
- un deuxième substrat secondaire (6), le deuxième substrat secondaire comprenant au moins une source lumineuse (9) destinée à être commandée par le pilote (2) du substrat principal (1), et des pistes électriques qui partent d'une partie de bord (61) du deuxième substrat secondaire (6) et relient la partie de bord (61) à la source lumineuse (9) ;
- un deuxième connecteur secondaire (7) couplé à la partie de bord (61) du deuxième substrat secondaire (6), le deuxième connecteur secondaire (7) comprenant au moins quatre entrées (71), chaque entrée (71) étant connectée par fil avec une sortie (52) du premier connecteur secondaire (5).

2. Dispositif lumineux automobile selon la revendication 1, dans lequel
- le deuxième connecteur secondaire comprend en outre au moins quatre sorties (72) ;
- le dispositif d'éclairage comprend en outre un troisième substrat secondaire (12) et un troisième connecteur secondaire (13) ;
- le troisième substrat secondaire (12) comprend au moins une source lumineuse (9) destinée à être commandée par le pilote du substrat principal, et des pistes électriques qui partent d'une partie de bord (14) du troisième substrat secondaire (12) et relient la partie de bord (14) à la source lumineuse (9) ; et
- le troisième connecteur secondaire (13) est couplé à la partie de bord (14) du troisième substrat secondaire (12), le troisième connecteur secondaire (13) comprenant au moins quatre entrées (15), chaque entrée étant connectée par fil avec une sortie (72) du deuxième connecteur secondaire.

3. Dispositif lumineux automobile selon l'une quelconque des revendications précédentes, dans lequel l'une des pistes électriques est configurée pour fournir des informations sur la connexion électrique entre le connecteur correspondant et la partie de bord correspondante.

4. Dispositif lumineux automobile selon la revendication 3, dans lequel la piste électrique configurée pour fournir des informations sur la connexion électrique entre le connecteur correspondant et la partie de bord correspondante est disposée dans un circuit électrique indépendant qui est séparé de la source lumineuse.

5. Dispositif lumineux automobile selon la revendication 4, dans lequel le circuit électrique indépendant comprend une première branche (21) qui relie la piste électrique configurée pour fournir des informations sur la connexion électrique avec le pilote et une seconde branche (22) avec une résistance (23), qui relie un nœud de la première branche (21) à la masse.

6. Dispositif lumineux automobile selon la revendication 4, comprenant en outre un dissipateur thermique (8), et dans lequel le circuit électrique indépendant comprend une première branche (21) qui relie la piste électrique configurée pour fournir des informations sur la connexion électrique avec le dissipateur thermique (8) et une seconde branche (22) avec une résistance (23), qui relie un nœud de la première branche à la masse.

7. Dispositif lumineux automobile selon l'une quelconque des revendications précédentes, dans lequel l'une des pistes électriques est configurée pour fournir des informations de diagnostic concernant l'état de la source lumineuse du substrat correspondant.

8. Dispositif lumineux automobile selon l'une quelconque des revendications précédentes, dans lequel les entrées et les sorties d'au moins l'un des connecteurs sont situées sur des faces opposées du connecteur correspondant.

9. Dispositif lumineux automobile selon l'une quelconque des revendications précédentes, dans lequel
- au moins l'un des connecteurs comprend des premiers moyens de retenue mécanique (16) et le substrat correspondant comprend des seconds moyens de retenue mécanique (17) configurés pour coopérer avec les premiers moyens de retenue mécanique pour retenir le connecteur
- les premiers moyens de retenue mécanique (16) et les seconds moyens de retenue mécanique (18) comprennent une paire bras-saillie, ou une paire crochet-loquet ou une connexion à encliquetage.

10. Dispositif lumineux automobile selon l'une quelconque des revendications précédentes, dans lequel les connecteurs sont des connecteurs de bord de carte et les sources lumineuses sont des sources lumineuses à semi-conducteurs, telles que des diodes électroluminescentes.
